# FASCICULE DE BREVET EUROPEEN

(11) **EP 3 680 904 B1**
(45) Date de publication et mention de la délivrance du brevet: **01.12.2021**
(21) Numéro de dépôt: 20151007.0
(22) Date de dépôt: 09.01.2020
(51) Int. Cl.: G11C 7/10, G11C 11/419

(54) **CIRCUIT DE DETECTION DE DONNEE PREDOMINANTE DANS UNE CELLULE MEMOIRE**
DETEKTIONSSCHALTKREIS EINES VORHERRSCHENDEN DATENINHALTS IN EINER SPEICHERZELLE
CIRCUIT FOR DETECTING PREDOMINANT DATA IN A MEMORY CELL

(30) Priorité: 10.01.2019 FR 1900222
(43) Date de publication de la demande: 15.07.2020
(73) Titulaire: Commissariat à l'énergie atomique et aux énergies alternatives, 75015 Paris (FR)
(72) Inventeur: NOEL, Jean-Philippe, 38054 Grenoble Cedex 09 (FR); BOUMCHEDDA, Réda, 38054 Grenoble Cedex 09 (FR); GIRAUD, Bastien, 38054 Grenoble Cedex 09 (FR); BOURDE-CICE, Emilien, 38054 Grenoble Cedex 09 (FR)
(74) Mandataire: Brevalex

(56) Documents cités:
- EP-A1- 3 252 774
- US-A- 3 593 304
- US-A1- 2010 172 190

## Description

### DOMAINE TECHNIQUE ET ÉTAT DE LA TECHNIQUE ANTÉRIEURE

La présente demande concerne le domaine technique des circuits mémoires, en particulier ceux dotés de points mémoire comprenant un ou plusieurs ports de lecture complémentaires et auxiliaires permettant d'effectuer une lecture sur un point mémoire sans en affecter le contenu. Elle s'applique notamment aux mémoires SRAM pour (« Static Random Access Memory »).

De façon classique un dispositif de calcul numérique tel que par exemple un microprocesseur est doté d'une mémoire interne et d'une unité arithmétique et logique (ALU) adaptée à la mise en œuvre des opérations arithmétiques et/ou logiques de base pour traiter des données contenues dans la mémoire interne.

Pour permettre d'augmenter la vitesse de certains traitements de données et/ou limiter la consommation énergétique liée à ces traitements, des dispositifs de calcul en mémoire (en anglais « In Memory Computing »), formés d'un circuit mémoire adapté pour mettre en œuvre des opérations de calculs sont apparus. Le document US 2010/172190 décrit un exemple d'un tel dispositif.

Il se pose le problème de trouver un nouveau dispositif mémoire adapté pour réaliser l'investigation du contenu d'un ensemble de cellules mémoires durant une opération de lecture.

### EXPOSÉ DE L'INVENTION

Selon un aspect, la présente demande concerne un dispositif mémoire comprenant une matrice de cellules mémoires, la matrice étant dotée d'au moins une première colonne de cellules dans laquelle chacune desdites cellules comprend :
- au moins un premier nœud de stockage pour stocker une donnée logique en particulier *'*1*'* ou *'*0*'*, dont la valeur correspond à celle d'au moins un potentiel au premier nœud de stockage,
- au moins un port de lecture pour lorsqu'il est activé, transmettre le potentiel du premier nœud de stockage à une première ligne de bit partagée par les cellules de la première colonne de cellules,
   le dispositif étant doté en outre d'un circuit de détection, encore appelé circuit de test configuré pour, lors d'une opération de lecture, effectuer une phase de test pour indiquer si la proportion de cellules dans ladite colonne stockant une même donnée logique, en particulier un '1' logique, est supérieure ou non à au moins un seuil prédéterminé, ledit circuit de test comprenant :
- un premier nœud de lecture couplé à une extrémité de la première ligne de bit,
- un deuxième nœud de lecture couplé à une extrémité d'une deuxième ligne de bit, la deuxième ligne de bit étant associée à une pluralité de deuxièmes nœuds de stockage d'information logique, lesdits deuxièmes nœuds de stockage étant configurés de sorte à stocker tous la même information logique ou appartenant respectivement auxdites cellules de ladite première colonne et étant des nœuds de stockage complémentaires desdits premiers nœuds,
   ledit circuit de test étant configuré pour :
- activer concomitamment k ports de lecture respectifs d'un nombre k de cellules de ladite première colonne tout en activant simultanément k autres ports de lecture d'un nombre k correspondant de deuxièmes nœuds de stockage auxquels ces autres ports de lecture sont associés, pour entrainer une décharge de la première ligne de bit et une décharge de la deuxième ligne de bit et en conséquence une variation de potentiel audit premier nœud de lecture et au deuxième nœud de lecture puis, après une durée prédéterminée, en fonction de la différence de potentiels entre ledit premier nœud de lecture et ledit deuxième nœud de lecture :
- produire au moins un signal logique de résultat de test indiquant en fonction de sa valeur si la proportion de cellules dans ladite colonne stockant un niveau logique donné, en particulier un '1' logique, est supérieure ou non audit seuil prédéterminé.

Le seuil prédéterminé peut être ajusté par l'intermédiaire d'au moins un étage formant une résistance ajustable et couplé au moins au premier nœud de lecture. Le terme "couplé" est utilisé dans la présente description pour désigner une liaison électrique directe ou une liaison via un ou plusieurs composants intermédiaires (résistance, transistor, etc.).

Un tel circuit de test permet de connaitre le contenu (*'*1*'* ou *'*0*'*) prédominant dans une colonne de cellules mémoires en un seul cycle de lecture. En fonction de la valeur du seuil prédéterminé, il est possible par exemple de savoir s'il y a plus 25%, 50% ou 75% de '1' contenu dans la colonne de cellules testées.

Pour évaluer la prédominance d'une donnée par exemple un *'*1*'* logique dans une colonne de cellules mémoire, on réalise ici une lecture simultanément de ces cellules.

Chaque cellule mémoire testée contribue à la vitesse de décharge de la première ligne de bit et cette décharge est typiquement d'autant plus rapide qu'il y a de *'*1*'* stockés. Le circuit de test permet à partir de la vitesse ou de la pente de décharge d'évaluer le nombre de *'*1*'* logiques présents dans la colonne.

Selon un premier mode de réalisation du circuit de test, la deuxième ligne de bit est partagée par des cellules d'une colonne factice, les deuxièmes nœuds de stockage étant des nœuds de stockage de cellules mémoires factices stockant toutes la même donnée logique, en particulier un *'*1*'* logique.

On se sert dans ce mode de réalisation d'une colonne factice comme référence pour laquelle la vitesse de décharge de la ligne de bit ou d'évolution du deuxième nœud de lecture est connue.

Dans ce premier mode de réalisation, le premier nœud de lecture peut être connecté à l'étage de circuit formant une résistance ajustable et la valeur dudit seuil peut être modulée entre plusieurs valeurs prédéterminées correspondant à différentes valeurs prédéterminées de résistance dudit étage formant une résistance ajustable.

Avantageusement, cet étage formant une résistance ajustable est doté d'un ensemble de m transistors ayant chacun un état de conduction respectif passant ou bloqué et commandé par un signal de commande d'un ensemble de m signaux de commande respectifs des transistors, les transistors étant agencés en parallèle de sorte que la valeur de résistance dudit étage varie, en particulier diminue, en fonction du nombre de transistors rendus passants parmi les m transistors.

Les signaux de commande peuvent être des signaux logiques et l'ensemble des signaux de commande peut former un signal de sélection numérique dudit seuil à m états, en particulier avec m=3. Dans ce cas, les seuils prédéterminés peuvent avantageusement être respectivement de 25%, 50%, et 75%.

Le circuit de test peut être configuré pour après ladite phase de test, effectuer une deuxième phase de test pour indiquer si la proportion de cellules dans ladite colonne stockant un niveau logique donné, en particulier un *'*1*'* logique, est supérieure ou non à au moins un deuxième seuil prédéterminé et différent dudit seuil prédéterminé.

Avantageusement, le signal de résultat de test est produit au moyen d'un comparateur de tension intégré au circuit de test et dont la sortie est activée par le biais d'un signal de déclenchement, ledit comparateur de tension étant doté d'une première entrée connectée au premier nœud de lecture et d'une deuxième entrée connectée audit deuxième nœud de lecture.

De manière avantageuse, le premier nœud de lecture peut être connecté à une première portion de circuit configurée pour ralentir ladite variation de potentiel dudit premier nœud de lecture. Cette première portion de circuit peut comprendre au moins un transistor dont la conduction est contrôlée par un signal de contrôle de ralentissement dont l'amplitude dépend dudit nombre k de cellules de ladite première colonne dont les ports de lecture sont activés lors de ladite phase de test.

De manière avantageuse, le deuxième nœud de lecture peut être également connecté à une deuxième portion de circuit configurée pour ralentir ladite variation de potentiel dudit premier nœud de lecture, ladite deuxième portion de circuit comprenant au moins un transistor dont la conduction est contrôlée par un signal de contrôle de ralentissement dont l'amplitude est modulée en fonction du nombre k de cellules de ladite première colonne dont les ports de lecture sont activés.

Typiquement, un port de lecture d'une cellule est activé par le biais d'une ligne de mot partagée par les cellules d'une même ligne de cellules de la matrice, la matrice de cellules comportant plusieurs lignes et une pluralité de ligne de mot associées. Selon un aspect particulier, le circuit test peut alors comprendre en outre, un bloc de circuit pour produire le signal de contrôle de ralentissement à destination de ladite première portion de circuit et de ladite deuxième portion de circuit, ledit bloc étant doté d'une pluralité de transistors en parallèle, les lignes de mots de ladite pluralité de ligne de mot étant connectées respectivement aux grilles respectives desdits transistors dudit bloc.

Selon un deuxième mode de réalisation du circuit de test, la deuxième ligne de bit est une ligne de bit complémentaire de la première ligne de bit apte à être couplée aux nœuds de stockage complémentaires respectivement desdits premiers nœuds de stockage desdites cellules de ladite première colonne, et dans lequel un premier étage de circuit formant une première résistance ajustable est agencé entre la première ligne de bit et le premier nœud de lecture, et dans lequel un deuxième étage de circuit formant une deuxième résistance ajustable est agencé entre la ligne de bit complémentaire et le deuxième nœud de lecture, la valeur dudit seuil prédéterminé étant modulable en fonction des valeurs de ladite première résistance ajustable et de ladite deuxième résistance ajustable.

Dans ce cas, le premier étage de circuit formant la première résistance ajustable peut être avantageusement doté :
- d'un premier transistor ayant un état de conduction commandé par un premier signal d'activation,
- d'un deuxième transistor ayant un état de conduction commandé par un deuxième signal d'activation, le deuxième transistor ayant de préférence un rapport de la largeur sur la longueur de son canal différente et en particulier inférieure à celle dudit premier transistor.

Le deuxième étage de circuit formant la deuxième résistance ajustable peut être quant à lui doté :
- d'un troisième transistor ayant un état de conduction commandé par un troisième signal d'activation,
- d'un quatrième transistor ayant un état de conduction commandé par un quatrième signal d'activation, le quatrième transistor ayant un rapport de la largeur sur la longueur de son canal différente et en particulier inférieure à celle dudit troisième transistor.

De préférence, le premier transistor du premier étage est identique au troisième transistor dudit deuxième étage, le quatrième transistor du deuxième étage étant également de préférence identique au deuxième transistor dudit premier étage.

Avantageusement, l'ensemble desdits signaux d'activation forme un signal de sélection dudit seuil, ledit seuil étant sélectionné à une première valeur de 50% lorsque le premier signal d'activation et ledit troisième signal d'activation sont adaptés de sorte à rendre passant le premier transistor et le troisième transistor, tandis que le deuxième signal d'activation et le quatrième signal d'activation sont adaptés de sorte à bloquer respectivement le deuxième transistor et le quatrième transistor.

Le seuil de test peut être avantageusement sélectionné à une deuxième valeur, en particulier 25%, lorsque le premier signal d'activation et le quatrième signal d'activation sont adaptés de sorte à rendre respectivement passant le premier transistor et le quatrième transistor, tandis que le deuxième signal d'activation et le troisième signal d'activation sont prévus de sorte à bloquer le deuxième transistor et le troisième transistor.

Le seuil de test peut être avantageusement sélectionné à une troisième valeur, en particulier 75%, lorsque le premier signal d'activation et le quatrième signal d'activation sont prévus de sorte à rendre respectivement bloqués le premier transistor et le quatrième transistor, tandis que le deuxième signal d'activation et le troisième signal d'activation sont prévus de sorte à passant le deuxième transistor et le troisième transistor.

Avantageusement, le signal de résultat de test peut être produit au moyen d'un amplificateur de lecture de tension intégré audit circuit de test, ledit amplificateur de lecture de tension étant doté d'une première entrée connectée au premier nœud de lecture et d'une deuxième entrée connectée audit deuxième nœud de lecture.

Le signal de résultat de test peut être enregistré en sortie d'une bascule à réception d'un signal de déclenchement.

Une application particulière du circuit de test consiste à utiliser ce circuit afin d'empêcher une tentative d'accès aux données mémoires.

Ainsi, on peut mettre en œuvre un procédé de commande du dispositif mémoire défini plus haut comprenant, consécutivement à une détection d'un signal indicateur d'une tentative d'accès frauduleux à ladite matrice de cellules, l'application d'un signal de commande modifiant la résistance dudit étage formant une résistance ajustable. La valeur lue sur le premier nœud est alors faussée.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
Les figures 1A-1C servent à illustrer différents exemples de structures de points mémoires susceptibles d'être intégrés à un dispositif mémoire et doté d'un circuit de test statistique de données contenues dans la mémoire et tel que mis en œuvre suivant l'invention ;
La figure 2 sert à illustrer un premier mode de réalisation d'un circuit de test permettant d'évaluer si dans un ensemble de cellules mémoire testées la proportion de cellules stockant la même donnée logique typiquement un *'*1*'* est supérieure ou non à un seuil prédéterminé, ce seuil étant ajustable et choisi entre plusieurs seuils prédéterminés ;

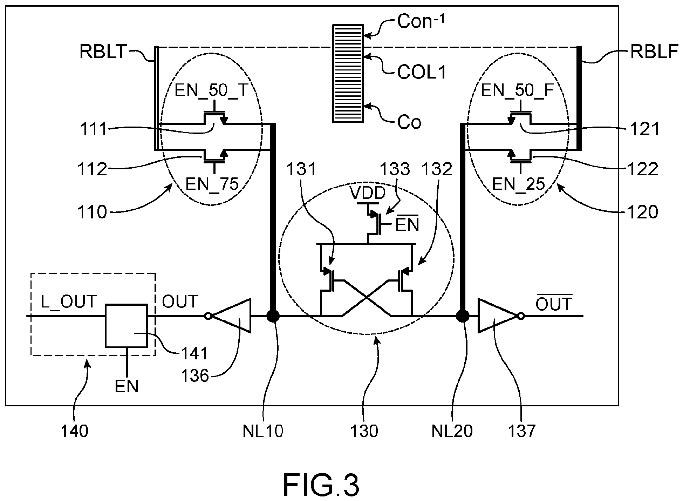

La figure 3 sert à illustrer un deuxième mode de réalisation du circuit de test à seuil ajustable pour tester une prédominance d'une donnée logique dans un ensemble de cellules d'un dispositif mémoire ;
La figure 4 sert à illustrer différents exemples de signaux mis en œuvre lors d'un premier test mis en œuvre par un circuit de test suivant l'invention pour lequel une colonne testée de cellules comporte une majorité de *'*1*'* et lors d'un deuxième test pour lequel une colonne testée de cellules comporte une minorité de '1' ;

En outre, dans la description ci-après, des termes qui dépendent de l'orientation du dispositif comme par exemple « verticale », « horizontale », s'appliquent en considérant que le dispositif est orienté de la façon illustrée dans les figures.

Des parties identiques, similaires ou équivalentes des différentes figures portent les mêmes références numériques de façon à faciliter le passage d'une figure à l'autre.

### EXPOSÉ DÉTAILLÉ DE MODES DE RÉALISATION PARTICULIERS

Un circuit de test tel que mis en œuvre suivant un mode de réalisation de la présente invention et permettant de connaitre le contenu prédominant dans une colonne de cellules mémoires est intégré à un dispositif mémoire doté d'une matrice mémoire formée d'une pluralité de lignes de cellules et d'une ou plusieurs colonnes de cellules mémoires.

Le circuit de test est implémenté sans modification de la structure interne des cellules mémoire et ne requiert la mise en œuvre que d'un nombre restreint d'éléments additionnels périphériques à la matrice de cellules.

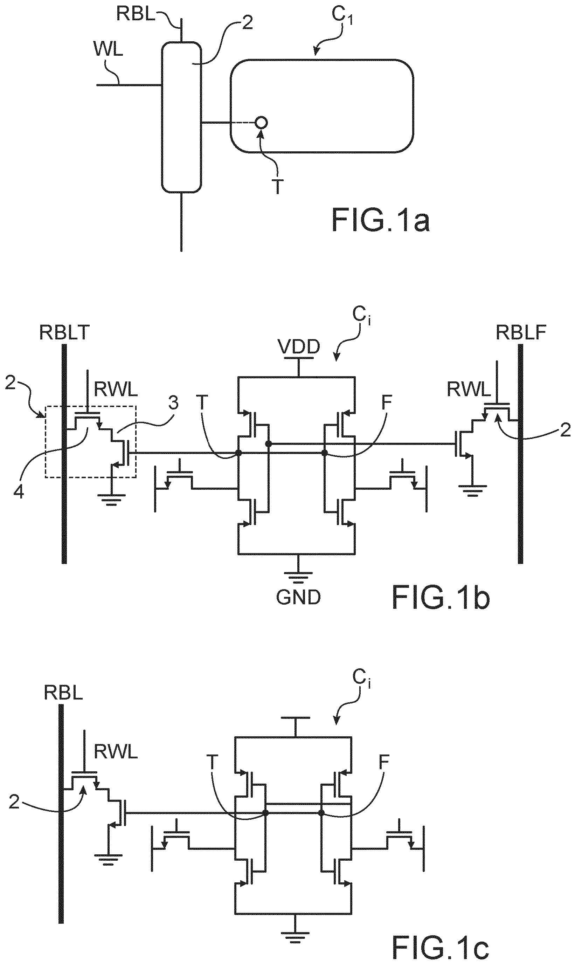

Une cellule mémoire Ci (également appelée point mémoire) du dispositif mémoire auquel le circuit de test est intégré peut avoir un agencement tel qu'illustré de manière schématique sur la figure 1A.

La cellule Ci représentée est dotée d'au moins un nœud de stockage T, prévu pour conserver une donnée, typiquement un *'*1*'* ou un '0', en fonction d'une valeur de potentiel maintenu sur ce nœud T.

La cellule Ci comporte également un port de lecture 2 pour, lorsqu'il est activé par le biais d'une ligne de mot WL, permettre de relier le premier nœud T de stockage à une ligne de bit RBL partagée par les cellules d'une même colonne (i.e. une rangée verticale) de cellules que la cellule Ci. La ligne de bit RBL peut être en particulier une ligne de bit dédiée aux opérations de lecture sur la cellule Ci. La ligne de mot WL est typiquement partagée par les cellules d'une même ligne (i.e. une rangée horizontale) de cellules de la matrice que la cellule Ci.

Le port 2 de lecture comprend typiquement un ou plusieurs transistors d'accès (non représentés sur cette figure) dont la conduction est commandée par un signal appliqué sur la ligne de mot WL. Le port 2 de lecture est de préférence un port de lecture auxiliaire ou spécifique aux opérations de lecture et conçu de sorte que lors d'une opération de lecture lorsque la ligne de bit RBL est couplée au nœud de stockage T, la donnée logique stockée par le nœud T est maintenue et n'est pas affectée.

Un mode de réalisation particulier prévoit un dispositif mémoire formé de cellules de type SRAM. Ce type de cellule est typiquement doté de deux nœuds de stockage T et F, prévus pour conserver une première donnée logique, et une donnée logique complémentaire de la première donnée, le maintien des données logiques aux nœuds T, F étant assuré par des transistors formant des inverseurs bouclés sur eux-mêmes.

La cellule SRAM peut dans ce cas être par exemple une cellule à 6 transistors (6T) ou bien une cellule à 8 transistors (8T ou 6T+2T) et munie d'un seul port de lecture 2 telle que par exemple celle illustrée sur la figure 1C. Une cellule munie de deux ports de lecture 2 et par exemple formée de 10 transistors (10T) telle que celle illustrée par exemple sur la figure 1B peut être également prévue.

Dans les deux exemples des figures 1B et 1C, un port de lecture 2 peut être formé de plusieurs transistors d'accès 21, 22. Un premier transistor d'accès 3 a sa grille connectée à un nœud de stockage et un deuxième transistor 4 d'accès a sa grille connectée à une ligne de mot RWL cette fois dédiée aux opération de lecture et différente d'une ligne de mot d'écriture et son drain connecté à une ligne de bit RBL, RBL_{T}, RBL_{F} de lecture qui n'est utilisée dans cet exemple que pour les opérations de lecture et n'est pas utilisée pour l'écriture. Lorsque la ligne à laquelle la cellule Ci appartient ne fait pas l'objet d'un accès en lecture, la ligne de mot RWL étant non-activé autrement dit typiquement à un potentiel nul dans le cas d'un transistor d'accès de type N, le chemin entre la ligne de bit RBL et la masse est coupée. Une opération de lecture sur la cellule est déclenchée lorsque la ligne de mot RWL est activée, autrement dit qu'un signal émis sur cette dernière permet d'accéder au nœud de stockage T ou F associé à cette ligne de mot RWL.

Un circuit de test tel que mis en œuvre suivant l'invention peut ainsi permettre d'évaluer la prédominance d'une même donnée logique dans un ensemble de cellules mémoires telles que décrites plus haut et appartenant à une même colonne de cellules. En particulier, on peut évaluer la prédominance de cellules contenant un '1' logique dans une colonne de cellules.

Plus généralement, le circuit de test est adapté pour évaluer si parmi les cellules testées d'une colonne de cellules, le pourcentage ou la proportion de cellules stockant un même niveau logique donné, en particulier un *'*1*'* logique, est supérieur ou non à au moins seuil prédéterminé ajustable, ce seuil pouvant être fixé par exemple à 25% ou par exemple à 50% ou par exemple à 75%. Le seuil prédéterminé peut être ainsi sélectionnée entre une pluralité de seuils prédéterminés, par exemple entre trois seuils : avantageusement 25%, 50% et 75%.

Le circuit de test est configuré pour effectuer une telle phase de test lors d'une opération de lecture ou d'un cycle de lecture, en effectuant une lecture simultanée de plusieurs cellules testées, autrement dit en réalisant un accès simultané aux ports de lecture respectifs de plusieurs cellules testées.

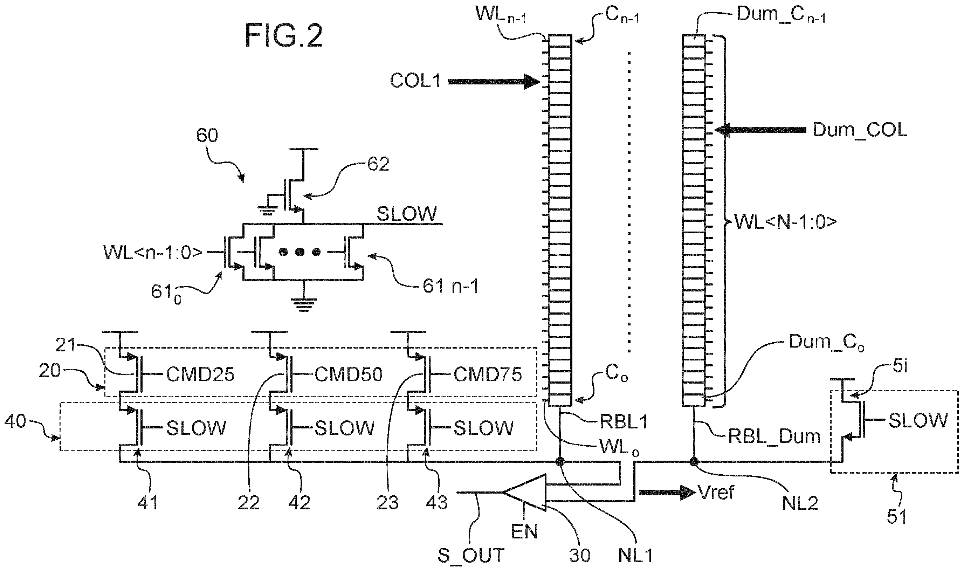

Un exemple de réalisation d'un tel circuit 10 de test tel que mis en œuvre suivant un premier mode de réalisation de la présente invention est donné sur la figure 2.

Le circuit 10 de test est ici représenté par souci de simplification avec une seule colonne COL₁ de n cellules mémoires C₁,..., Cₙ (avec n par exemple égal à 32) sur laquelle on souhaite effectuer un test d'occurrence de donnée afin de déterminer si le pourcentage ou le taux de cellules stockant la même donnée parmi l'ensemble de toutes les cellules de cette colonne COL₁ ou parmi un groupe de cellules de cette colonne COL₁ est supérieur ou non à un seuil prédéterminé. Typiquement, on effectue un test statistique sur la donnée logique *'*1*'* en vérifiant par exemple si oui ou non au moins M% de cellules stockent la donnée logique '1'. Le seuil M de test est par exemple réglé à 50% ou à 25% ou à 75%.

Le test peut être réalisé sur un nombre prédéterminé de k (avec 2 ≤ k ≤ n) cellules de la colonne COL₁, en fonction du nombre k de lignes de mots activées simultanément lors de ce test, parmi un ensemble de n lignes de mots WL₀,..., WLₙ₋₁.

Selon une possibilité de mise en œuvre, le circuit de test peut comprendre ou être associé à un circuit d'activation (non représenté) qui peut être intégré à un décodeur de lignes associé à la matrice et qui est configuré(e) pour effectuer une activation simultanée de lignes de mot, de manière à effectuer une sélection simultanée de différentes rangées de ports de lecture respectifs de cellules de la colonne COL₁ de cellules. Le décodeur de ligne peut être dans ce cas modifié de manière à pouvoir activer plusieurs lignes de mots en même temps voire toutes les lignes de mots en même temps en ajoutant par exemple une entrée supplémentaire ou en utilisant des sorties de colonnes CAM (« Content Adressable Memories »).

La colonne COL₁ testée est associée à une ligne de bit RBL₁ à l'extrémité de laquelle se situe un premier nœud de lecture NL₁.

Pour effectuer le test sur la colonne COL₁, le circuit 10 est également doté d'une colonne de référence qui, dans cet exemple de réalisation, est une colonne Dum_COL factice (en anglais « dummy ») composée de n cellules mémoires factices (« dummy cells »), c'est-à-dire qui servent de référence ou de cellules témoins plutôt que de moyen dans lequel on est amené à écrire une donnée à stocker. Les cellules factices Dum_C₀,... Dum_Cₙ₋₁ de la colonne factice Dum_COL permettent de produire des signaux électriques de référence. Typiquement, les cellules factices sont en nombre n (avec n par exemple égal à 32) égal à celui d'une colonne COL1 de la matrice et peuvent avoir une structure semblable à celles des autres cellules de la matrice mémoire et par exemple telles que décrites précédemment en liaison avec les figures 1A-1C.

Dans cet exemple de réalisation, les cellules factices Dum_C₀,..,Dum-Cₙ₋₁ et leur nœud de stockage associé sont configurées de sorte à stocker une même donnée logique, par exemple un '1' logique. Les cellules factices peuvent être ainsi dotées d'au moins un nœud de stockage constamment forcé à un potentiel donné par exemple d'alimentation VDD de manière à obtenir ainsi une cellule sur laquelle on peut accéder en lecture sans pouvoir réaliser un accès en écriture. De telles cellules factices Dum_C₀,..,Dum_Cₙ₋₁ permettent ainsi de produire une donnée de référence qui reste la même pour tous les accès en lecture et tests effectués. La colonne factice Dum_COL est associée à une ligne de bit RBL_Dum à l'extrémité de laquelle se situe un deuxième nœud de lecture NL₂.

Prélablement à la phase de test et à un cycle de lecture, la première ligne de bit RBL₁ et de la ligne de bit RBL_Dum associée à la colonne Dum_COL factice sont typiquement pré-chargées par le biais d'un circuit de pré-charge (non représenté), par exemple à un potentiel d'alimentation VDD. Ce circuit de pré-charge peut être agencé à une extrémité de la ligne de bit RBL₁ et à une extrémité de la ligne de bit RBL_Dum opposée à celle où se situent respectivement le premier nœud de lecture NL₁ et le deuxième nœud de lecture NL₂.

Lors d'une lecture ou d'un test effectué sur k (avec 1 < k ≤ n, avec k de préférence proche de n) cellules de la colonne COL₁, la pré-charge de la ligne de bit RBL₁ est désactivée préalablement à l'activation simultanée de k lignes de mot donnée WL₀,..., WLₙ₋₁. Cette activation des k lignes de mot WL₀,..., WLₙ₋₁ permet d'activer simultanément les k ports de lecture respectifs des cellules testées ainsi que les k ports de lecture respectifs des cellules factices.

Une partie de la phase de test consiste à attendre que les lignes de bits RBL1 et RBL_Dum se déchargent, ce qui permet de faire varier, dans cet exemple d'augmenter, les potentiels respectifs des nœuds NL₁ et NL₂.

Le premier nœud NL₁ a un potentiel qui varie à une vitesse qui dépend du nombre (inconnu) de '1' logiques présents dans l'ensemble des k cellules de la colonne COL₁, tandis que la vitesse de décharge de la colonne factice dépend du nombre k (connu) de *'*1*'* logiques des k cellules activées de la colonne factice Dum_COL.

On utilise les vitesses ou la pente de décharge respectives des nœuds NL₁ et NL₂ pour évaluer si le nombre de *'*1*'* logiques dans la colonne COL₁ est supérieur ou non au seuil prédéterminé, par exemple de 25% ou de 50% ou de 75% de l'ensemble des cellules testée d'une colonne.

Dans ce mode de réalisation, le seuil réglable est réglé ici à l'aide d'un étage 20 de circuit formant une résistance ajustable connectée au premier nœud de lecture NL₁.

La résistance ajustable est dans cet exemple formée de branches de circuit couplées au premier nœud NL1 de lecture et dotées respectivement de transistors 21, 22, 23, avantageusement identiques en termes de conception et de dimensions. Les transistors 21, 22, 23, sont par exemple de type PMOS avec des sources respectives connectées à une alimentation VDD, des grilles respectives commandées respectivement par les signaux de commande CMD25, CMD50, CMD75 de seuil. Un premier signal de commande CMD25 permet de contrôler l'état de conduction passant ou bloqué du transistor 21, tandis qu'un deuxième signal de commande CMD50 de seuil permet de contrôler l'état de conduction passant ou bloqué du transistor 22, et qu'un troisième signal de commande CMD75 de seuil détermine l'état de conduction passant ou bloqué du transistor 23. La valeur de résistance est ainsi ajustée, en particulier diminuée, en fonction du nombre de transistors 21, 22, 23 rendus passants.

Une activation cumulative est mise en œuvre. Ainsi, lorsque l'on souhaite fixer le seuil de test à un premier niveau de seuil, par exemple de 25%, seul le transistor 21 est activé, tandis que lorsque l'on souhaite fixer le seuil de test à un deuxième niveau de seuil qui correspond à une vitesse de décharge plus importante de la première ligne de bit RBL1, par exemple un seuil de 50%, les transistors 21, 22 sont activés, ce qui dans cet exemple permet de diminuer la résistance de l'étage 20, en particulier de la diviser par 2. On active les transistors 21, 22, 23, par exemple pour diviser la résistance ajustable par 3 et fixer un seuil à un troisième niveau, par exemple de 75%, qui correspond à une évolution encore plus rapide du premier nœud de lecture NL1 lors de la phase de test. L'ensemble des signaux de commande CMD25, CMD50, CMD75 forme ainsi un signal d'ajustement de seuil qui peut être numérique. Par exemple un tel signal numérique prendre la valeur 001 (CMD75=0 ; CMD50=0 ; CMD25=1) pour fixer le seuil à 25%.

Au démarrage de la phase de test mise en œuvre lors d'un cycle de lecture, le potentiel au premier nœud lecture NL₁ s'établit compte tenu, initialement ou au début du test, de plusieurs phénomènes et notamment :
- d'une traction vers GND provoquée par l'activation des k ports de lecture par les k lignes de mots WL sélectionnées.
- d'une traction vers la tension VDD provoquée par la ou les branches sélectionnées de l'étage 20 dotée des transistors 21, 22, 23 pilotés respectivement par les signaux CMD25, CMD50, CMD75 permettant de choisir le seuil de comparaison : 25%, 50% ou 75%.

De même, le potentiel au deuxième nœud de lecture NL₂ s'établit compte tenu notamment d'une mise à GND provoquée par les k ports de lecture activés.

On effectue une comparaison du potentiel au premier nœud de lecture NL₁ et au deuxième nœud de lecture NL₂, au moyen d'un comparateur 30 de tension pourvu d'une première entrée connectée au premier nœud de lecture NL1 et d'une deuxième entrée NL2 connectée audit deuxième nœud de lecture, afin de pouvoir évaluer le niveau du potentiel du premier nœud de lecture NL1 en comparaison avec celle du deuxième nœud NL2 servant de référence. Un signal d'activation du comparateur 30 également appelé signal de déclenchement EN détermine lorsque ses entrées et le résultat qui résulte de la comparaison de ses entrées doit être pris en compte.

La fin de l'opération de test peut être déterminée de manière arbitraire, par exemple en utilisant un circuit contenant une chaine de retard (« delay chain ») qui produit le signal de déclenchement EN selon un retard déterminé après le début de la phase de test.

Un chemin de référence (« dummy path ») incluant le circuit de lecture et ayant un temps de propagation réglable en fonction de différents paramètres tels que le procédé, les niveaux de tensions mises en jeu, en particulier d'alimentation, la température, peut être en variante utilisé pour générer le signal de déclenchement EN.

Un exemple de réalisation d'un tel circuit est donné dans le document : « A Novel Dummy Bitline Driver for Read Margin Improvement in an eSRAM » de Michael Yap San Min et al., DELTA'08: Fourth IEEE International Symposium on Electronic Design, Test and Applications, Jan 2008, Hong Kong, China, IEEE Computer Society, pp.107-110, 2008, en particulier en lien avec la figure 1.

Un autre exemple de réalisation est donné dans le document "A 28nm 6T SRAM memory compiler with a variation tolerant replica circuit" SoC Design Conférence (ISOCC), 2012 International.

Le comparateur 30 permet de délivrer un signal logique de résultat de test S_OUT qui, en fonction de son état *'*1*'* ou '0' indique si oui (par exemple état '1') ou non (état '0') la proportion de cellules testées stockant la valeur '1' dépasse le seuil de test, par exemple de 50 % de cellules.

Pour pallier une variation trop rapide de potentiel au premier nœud de lecture NL1 lors de la phase de test décrite précédemment effectuée pendant un cycle de lecture, on peut prévoir une portion 40 de circuit configurée pour ralentir la variation de potentiel du premier nœud de lecture NL1. Cette portion 40 de circuit est ici dotée de transistors 41, 42, 43, par exemple de type PMOS, mis en série avec les transistors 21, 22, 23 de l'étage 20 formant une résistance ajustable. La conduction des transistors 41, 42, 43 servants à la mise en œuvre du ralentissement est contrôlée par un signal de contrôle de ralentissement SLOW appliqué sur leur grille. Ce signal SLOW a une amplitude qui dépend du nombre k de cellules de ladite première colonne COL₁ dont les ports de lecture sont activés lors de la phase de test.

Pour pallier une variation trop rapide de potentiel du deuxième nœud de lecture NL2 lors de la phase de test décrite précédemment effectuée pendant une opération de lecture, on peut également prévoir une portion 50 de circuit dotée d'un transistor 52, par exemple de type PMOS relié à un potentiel par exemple VDD et dont la conduction est contrôlée par le même signal de contrôle de ralentissement SLOW.

Un exemple de bloc 60 permettant de produire le signal SLOW de contrôle de ralentissement à destination des transistors 41, 42 est donné sur la figure 2.

Le bloc 60 est également formé de n transistors 61₁, ..., 61ₙ, par exemple de type NMOS, à source commune et drain commun et qui sont ainsi agencés en parallèle.

Chacune des grilles des transistors est commandée par une ligne de mot propre parmi les n lignes de mots WL₀,..., WLₙ₋₁ permettant d'accéder en lecture aux n cellules d'une colonne de cellules. Les lignes de mots WL₀,..., WLₙ₋₁ sont ainsi respectivement reliées aux grilles respectives desdits n transistors 61₁, ..., 61ₙ. Le signal SLOW prélevé au drain commun des transistors 61₀, ..., 61ₙ₋₁ dépend par conséquent du nombre de lignes de mots WL₀,..., WLₙ₋₁ activées lors de la phase de test. Plus il y a de lignes de mots WL₀,..., WLₙ₋₁ et donc de cellules de la colonne COL1 lues, activés, plus ce signal SLOW se rapproche dans cet exemple du potentiel de référence GND, ce qui a tendance à augmenter la conductivité des transistors 21, 22, 23. Le bloc 60 est typiquement doté également d'un transistor PMOS 62, servant de générateur et dont le drain est connecté à l'alimentation VDD, la grille maintenue à la masse et la source connectée à un nœud délivrant signal de contrôle de ralentissement SLOW.

Dans le cas où les n (avec n par exemple égal à 32) lignes de mots 32 sont activées, la ligne de bit RBL₁ et la ligne de bit de référence RBL_dummy sont fortement tirées à GND via les ports de lecture, mais dans ce cas le signal SLOW très proche de GND active l'ensemble des transistors 61₁, ..., 61ₙ PMOS de sorte à maintenir les nœuds NL₁ et NL₂ éloignés de GND.

On peut souhaiter affiner le résultat de test obtenu à l'issue d'une phase de test mise en œuvre lors d'un cycle de lecture. Pour cela, une séquence de plusieurs tests lors de laquelle le seuil est modifié peut être mise en œuvre.

Par exemple, on effectue un premier test avec un premier seuil, par exemple de 25% correspondant à un premier ensemble de valeurs de signaux de commande CMD25, CMD50, CMD75 qui détermine une première valeur de résistance de l'étage 20 est mis en œuvre. On calibre ainsi de cette manière la variation de potentiel du premier nœud de lecture NL1 lorsque les ports de lecture sont activés et que la première ligne de bit RBL1 se décharge. Puis, si par exemple le signal S_OUT indique que le nombre de cellule stockant la valeur *'*1*'* est supérieur à 25% on peut effectuer un deuxième test afin de réaliser une évaluation plus précise de la quantité de '1' stockée.

On peut alors effectuer un deuxième test avec un deuxième seuil, par exemple de 50% correspondant à un deuxième ensemble de valeurs de signaux de commande CMD25, CMD50, CMD75 qui détermine une deuxième valeur de résistance de l'étage 20.

Lorsque la quantité de '1' stockée dans la colonne testée est proche du deuxième seuil, en l'occurrence de 50%, le résultat du test effectué peut être incertain. On peut alors effectuer un troisième test avec un troisième seuil, par exemple de 75% correspondant à un troisième ensemble de valeurs de signaux de commande CMD25, CMD50, CM75 qui détermine une troisième valeur de résistance de l'étage 20. Le signal S_OUT indique alors que le nombre de cellule stockant la valeur *'*1*'* est inférieur à 75%.

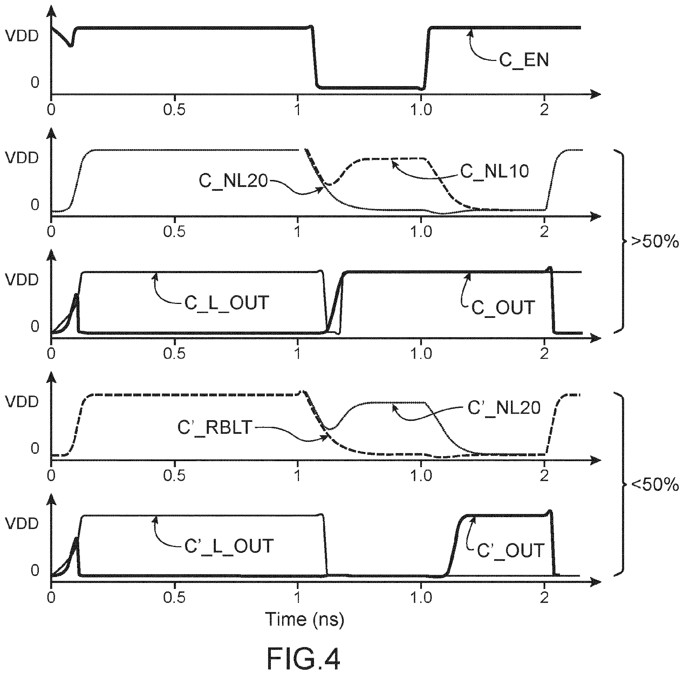

Une variante de réalisation de circuit de test dont la consommation énergétique est réduite est donnée sur la figure 4.

Elle s'applique à la mise en œuvre d'un test sur une colonne COL1 de cellules, par exemple de type SRAM, dotées de nœuds de stockage complémentaires stockant respectivement une donnée logique et sa donnée complémentaire.

Comme dans l'exemple de réalisation précédent, on évalue le contenu de la colonne COL1 de cellules C₀,...,Cₙ₋₁ en utilisant une première ligne de bit RBLT, destinée, lors d'une phase de test effectuée lors d'un cycle de lecture, à être mise au potentiel d'un premier nœud de stockage des cellules de la première colonne, et dont on évalue la vitesse de décharge au niveau d'un premier nœud de lecture NL10 couplé à cette première ligne de bit RBLT. Cette fois, plutôt que d'utiliser les nœuds de stockage d'une colonne factice de cellules, on utilise une deuxième ligne de bit RBLF, destinée lors d'une phase de test effectuée lors d'un cycle de lecture à être mise au potentiel d'un deuxième nœud de stockage des cellules de la première colonne, complémentaire du premier nœud. On évalue la vitesse de décharge de la deuxième ligne de bit RBLF, qui renseigne sur les potentiels respectifs des deuxièmes nœuds de stockage et donc sur les données logiques stockées par ces deuxièmes nœuds à partir d'un deuxième nœud de lecture NL20 couplé à deuxième ligne de bit RBLF.

Le circuit de test est cette fois doté d'un premier étage 110 de circuit formant une première résistance ajustable et qui est agencé entre une extrémité de la première ligne de bit RBLT et le premier nœud NL10 de lecture.

Dans cet exemple de réalisation, la première résistance ajustable est réalisée par le biais d'un transistor 111, par exemple de type NMOS, et d'un autre transistor 112 en parallèle, par exemple de type NMOS. Les transistors 111, 112 ont des drains respectifs couplés à la première ligne de bit RBLT et des sources respectives couplées au premier nœud de lecture NL10.

Le transistor 111, a un état de conduction commandé par un signal d'activation EN_50_T appliqué sur sa grille, tandis que le transistor 112 a un état de conduction commandé par un autre signal d'activation EN_75 appliqué sur sa grille.

Le circuit de test est également doté d'un deuxième étage 120 de circuit formant une deuxième résistance ajustable et qui est agencé entre une extrémité de la ligne de bit RBLF complémentaire de la colonne COL₁ et le deuxième nœud NL20 de lecture.

La deuxième résistance ajustable peut être également réalisée par le biais de transistors en parallèle, avec un transistor 121, par exemple de type NMOS, et un autre transistor 122, par exemple de type NMOS, ayant des drains connectés entre eux et à une extrémité de la deuxième ligne de bit RBLF et des sources respectives connectées au deuxième nœud de lecture NL20.

Le transistor 121, est quant à lui rendu passant ou bloqué en fonction d'un signal d'activation EN_50_F appliqué sur sa grille, tandis que le transistor 122 peut être quant à lui rendu passant ou bloqué par l'intermédiaire d'un signal d'activation EN_25 appliqué sur sa grille.

Les transistors 111, 121 sont de préférence identiques. Les transistors 112, 122 sont également de conception et taille identiques. Les transistors 112, 122 sont prévus avec des dimensions différentes de celles des transistors 111, 121, en particulier avec des rapports W/L (largeur sur longueur de la région de canal) différents. Dans cet exemple les transistors 112, 122 sont prévus avec une largeur W2 inférieure à celle W1 des transistors 111, 121.

Dans cet exemple de réalisation, lorsque le seuil de test est fixé à 50%, par exemple lorsque le test vise à déterminer si la colonne COL1, compte une majorité de *'*1*'* au niveau des premiers nœuds de stockage des cellules de cette colonne COL1, la résistance du premier étage 110 et celle du deuxième étage 120 sont rendues équilibrées par mise en conduction des transistors 111, 121 tandis que les transistors 112, 122 ne sont pas activés.

Les transistors 112, 122 permettent d'établir d'autres seuils de test en créant un déséquilibre de résistance entre le premier étage 110 et le deuxième étage 120.

Dans cet exemple de réalisation, un deuxième seuil de test par exemple de 25%, est établi en mettant en conduction le transistor 111 du premier étage 110 et le transistor 122 du deuxième étage 120, tandis que les transistors 112, 121 ne sont pas activés autrement dit sont mis dans un état bloqué. Cette deuxième configuration, où la résistance du premier étage 110 est inférieure à celle du deuxième étage 120 permet par exemple de déterminer si oui ou non la colonne COL1, compte au moins 25% de *'*1*'* au niveau des premiers nœuds de stockage des cellules.

Un troisième seuil de test peut être également établi en mettant en conduction le transistor 112 du premier étage 110 et le transistor 121 du deuxième étage 120, tandis que les transistors 111, 122 ne sont pas activés autrement dit sont dans un état bloqué. Cette troisième configuration, où la résistance du premier étage 110 est cette fois supérieure à celle du deuxième étage 120 permet par exemple de déterminer si oui ou non la colonne COL1, compte au moins 75% de *'*1*'* au niveau des premiers nœuds de stockage des cellules.

Les signaux d'activation EN_50_T, EN_50_F, EN_25, EN_75 sont typiquement des signaux logiques. L'ensemble des signaux d'activation EN_50_T, EN_50_F, EN_25, EN_75 forme un signal numérique de sélection de seuil qui, dans l'exemple de réalisation particulier décrit précédemment est susceptible d'adopter 3 états différents en fonction du seuil sélectionné parmi 3 seuils de tests disponibles, par exemple 25%, 50%, 75%. Un nombre de seuil plus important pourrait être envisagé en augmentant le nombre de transistors des étages 110, 120 et de signaux d'activation associé.

Consécutivement à une activation simultanée des ports de lecture respectifs des premiers nœuds de stockage et des nœuds de stockage complémentaires, la décharge de la première ligne de bit se réalise à une vitesse qui dépend du nombre de '1' logiques stockés dans l'ensemble des nœuds de stockage testés et qui est différente de celle de la ligne de bit complémentaire.

Cette différence de vitesse de charge des lignes se traduit par un déséquilibre entre le premier nœud de lecture NL10 et le deuxième nœud de lecture NL20. Ce déséquilibre est amplifié par le biais d'un amplificateur de lecture 130.

L'amplificateur de lecture peut être formé de transistors de charge 131, 132, par exemple de type PMOS connectés entre eux de manière croisée, de sorte que la grille d'un transistor 131 de charge est reliée au deuxième nœud NL20 de lecture, tandis que la grille de l'autre transistor 132 de charge est reliée au premier nœud NL10 de lecture, le drain du transistor 132 de charge étant relié à la grille du transistor 131 de charge. Les transistors 131, 132 sont dotés d'une source commune susceptible d'être mise à un potentiel d'alimentation VDD par le biais d'un transistor interrupteur 133 dont la conduction dépend du signal de test. Le transistor 133 peut être par exemple un transistor 133 de type PMOS rendu passant par un signal E̅N̅ complémentaire du signal de déclenchement EN.

Un signal de résultat de test OUT est fourni en sortie d'un premier inverseur 136 connecté au premier nœud de lecture NL20, tandis que l'on peut prélever un signal complémentaire O̅U̅T̅ en sortie d'un autre inverseur 137 dont l'entrée est reliée au premier nœud de lecture NL10. Une bascule asynchrone 141 ou verrou 141 commandée par le signal de déclenchement EN permet d'enregistrer la valeur du résultat de test, sous forme d'un signal L_OUT.

Le tableau ci-dessous résume les différents états possibles des signaux d'activation EN_50_T, EN_50_F, EN_25, EN_75 des étages 110, 120 formants des résistances ajustables pour sélectionner différents seuils de test dont le résultat est signifié par le signal de résultat de test OUT.

| **Test de lecture** | **Configuration signaux d'activation** | | | | **Résultat** | |
|---|---|---|---|---|---|---|
| | **EN_50_T** | **EN_5Ω_F** | **EN_25** | **EN_75** | **OUT** | |
| **25%** | **1** | **0** | **1** | **0** | **1 (> 25%)** | **0 (< 25%)** |
| **50%** | **1** | **1** | **0** | **0** | **1 (> 50%)** | **0 (< 50%)** |
| **75%** | **0** | **1** | **0** | **1** | **1 (> 75%)** | **0 (< 75%)** |

Sur la figure 4, des courbes d'évolution C_EN, C_NL20, C_NL10, C_OUT, C_OUT_Iatch donnent des exemples de courbes d'évolution respectivement du signal EN de déclenchement, du signal pris au deuxième nœud NL20, du signal pris au premier nœud NL10, du signal OUT de sortie du premier inverseur, et du signal de résultat de test en sortie de la bascule, ce pour un test effectué sur une colonne de cellules comportant plus de 50% de cellules stockant la valeur '1'.

D'autres courbes d'évolution C'_NL20, C'_NL10, C'_OUT, C'_OUT_latch donnent quant à elles des exemples de courbes d'évolution respectivement du signal pris au deuxième nœud NL20, du signal pris au premier nœud NL10, du signal OUT de sortie du premier inverseur, et du signal de résultat de test en sortie de la bascule, ce pour un test effectué sur une colonne de cellules comportant cette fois moins de 50% de cellules stockant la valeur '1'.

Un circuit de test intégré dans un dispositif mémoire et tel que décrit plus haut trouve notamment des applications dans le domaine du traitement d'image.

Un circuit de test intégré dans un dispositif mémoire et tel que décrit précédemment peut être appliqué à une protection de données de la mémoire.

Par exemple, lorsqu'une attaque visant à connaitre le contenu mémoire est détectée et qu'un signal de détection d'attaque est produit, on force de manière constante certains signaux de commande du circuit de test en particulier un ou plusieurs des signaux de commande EN_50_T, EN_75, EN_50_F, EN_25, ou bien l'un ou l'autre des signaux d'activation CMD25, CMD50 ou CMD75. La lecture d'une donnée qui serait réalisée sur le nœud de lecture NL1 ou NL10 serait alors faussée.

## Revendications

1. Dispositif mémoire comprenant une matrice de cellules mémoires, la matrice étant dotée d'au moins une première colonne (COL₁) de cellules (C₀, Cₙ₋₁) dans laquelle chacune desdites cellules comprend :
- au moins un premier nœud (T) de stockage pour stocker une donnée logique en particulier *'*1*'* ou '0', dont la valeur correspond à celle d'au moins un potentiel au premier nœud (T) de stockage,
- au moins un port de lecture (2) pour lorsqu'il est activé, transmettre le potentiel du premier nœud (T) de stockage à une première ligne de bit (RBL1, RBLT) partagée par les cellules (C₀, Cₙ₋₁) de la première colonne (COL1) de cellules,
le dispositif étant doté en outre d'un circuit de test configuré pour, lors d'une opération de lecture, effectuer une phase de test pour indiquer si la proportion de cellules dans ladite colonne (COL₁) stockant une même donnée logique, en particulier un '1' logique, est supérieure ou non à au moins un seuil prédéterminé, ledit circuit de test comprenant :
- un premier nœud de lecture (NL1, NL10) couplé à une extrémité de la première ligne de bit (RBL1, RBLT),
- un deuxième nœud de lecture (NL2, NL20) couplé à une extrémité d'une deuxième ligne de bit (RBL Dum, RBL₂), la deuxième ligne de bit formant une ligne de bit de référence associée à une pluralité de deuxièmes nœuds de stockage d'information logique, lesdits deuxièmes nœuds de stockage étant configurés de sorte à stocker tous la même information logique ou appartenant respectivement auxdites cellules de ladite première colonne et étant des nœuds de stockage complémentaires desdits premiers nœuds,
caractérisé en ce qui il comporte aussi
- au moins un étage (20, 110) formant une résistance ajustable pour ajuster ledit seuil prédéterminé, ledit étage étant couplé au moins au premier nœud de lecture,
ledit circuit de test (10, 100) étant configuré pour :
- activer concomitamment k ports de lecture respectifs d'un nombre k de cellules de ladite première colonne tout en activant simultanément k autres ports de lecture d'un nombre k correspondant de deuxièmes nœuds de stockage auxquels ces autres ports de lectures sont associés, pour entrainer une décharge de la première ligne de bit et une décharge de la deuxième ligne de bit et en conséquence une variation de potentiel audit premier nœud de lecture et au deuxième nœud de lecture puis après une durée prédéterminée, en fonction de la différence de potentiels entre ledit premier nœud de lecture et ledit deuxième nœud de lecture,
- produire au moins un signal logique (S_OUT, L_OUT) de résultat de test indiquant en fonction de sa valeur si la proportion de cellules dans ladite colonne (COL1) stockant un niveau logique donné, en particulier un *'*1*'* logique, est supérieure ou non audit seuil prédéterminé.

2. Dispositif mémoire selon la revendication 1, dans lequel la deuxième ligne de bit est partagée par des cellules d'une colonne factice (Dum_COL), les deuxièmes nœuds de stockage étant des nœuds de stockage de cellules mémoires factices (Dum_C0,... Dum_Cn-1) stockant toutes la même donnée logique, en particulier un *'*1*'* logique.

3. Dispositif mémoire selon la revendication 2, dans lequel le premier nœud de lecture (NL1) est connecté à l'étage (20) de circuit formant une résistance ajustable, la valeur dudit seuil étant modulable entre plusieurs valeurs prédéterminées correspondant à différentes valeurs prédéterminées de résistance dudit étage (20).

4. Dispositif mémoire selon la revendication 3, dans lequel l'étage (20) de circuit formant une résistance ajustable est doté d'un ensemble de m transistors (21, 22, 23) ayant chacun un état de conduction respectif passant ou bloqué et commandé par un signal de commande d'un ensemble de m signaux de commande (CMD25, CMD50, CM75) respectifs des transistors (21, 22, 23), les transistors étant agencés en parallèle de sorte que la valeur de résistance dudit étage varie, en particulier diminue, en fonction du nombre de transistors rendus passants parmi les m transistors.

5. Dispositif mémoire selon la revendication 4, l'ensemble des signaux de commande (CMD25, CMD50, CM75) forme un signal de sélection numérique à m états dudit seuil, en particulier avec m=3, les seuils prédéterminés étant avantageusement respectivement de 25%, de 50%, de 75%.

6. Dispositif selon l'une des revendications 2 à 5, dans lequel le circuit de test est configuré pour après ladite phase de test, effectuer une deuxième phase de test pour indiquer si la proportion de cellules dans ladite colonne stockant un niveau logique donné, en particulier un '1' logique, est supérieure ou non à au moins un deuxième seuil prédéterminé différent du premier seuil.

7. Dispositif mémoire selon l'une des revendications 2 à 6, dans lequel le signal (S_OUT) de résultat de test est produit au moyen d'un comparateur (30) de tension intégré au circuit de test dont la sortie est activée par le biais d'un signal de déclenchement (EN), ledit comparateur de tension étant doté d'une première entrée connectée au premier nœud de lecture (NL1) et d'une deuxième entrée connectée audit deuxième nœud de lecture (NL2).

8. Dispositif selon l'une des revendications 2 à 7, dans lequel le premier nœud (NL1) de lecture est connecté à une première portion (40) de circuit configurée pour ralentir ladite variation de potentiel dudit premier nœud de lecture (NL1), ladite première portion (40) de circuit comprenant au moins un transistor (41, 42, 43) dont la conduction est contrôlée par un signal de contrôle de ralentissement (SLOW) dont l'amplitude dépend dudit nombre k de cellules de ladite première colonne (COL1) dont les ports de lecture sont activés lors de ladite phase de test.

9. Dispositif selon l'une des revendications 2 à 8, dans lequel le deuxième nœud (NL2) de lecture est connecté à une deuxième portion (50) de circuit configurée pour ralentir ladite variation de potentiel dudit premier nœud de lecture, ladite deuxième portion (50) de circuit comprenant au moins un transistor (51) dont la conduction est contrôlée par un signal de contrôle de ralentissement (SLOW) dont l'amplitude est modulée en fonction du nombre k de cellules de ladite première colonne dont les ports de lecture sont activés.

10. Dispositif selon la revendication 9, dans lequel un port de lecture d'une cellule est activé par le biais d'une ligne de mot partagée par les cellules d'une même ligne de cellules de la matrice et dans lequel la matrice de cellules comporte plusieurs lignes et une pluralité de ligne de mot (WL₀,..., WLₙ₋₁) associées, ledit circuit test comprenant en outre un bloc (60) de circuit pour produire le signal de contrôle de ralentissement (SLOW) à destination dudit transistor (41, 42, 43) de ladite première portion (40) de circuit et dudit transistor (51) de ladite deuxième portion (50) de circuit, ledit bloc (60) de circuit étant doté d'une pluralité de transistors (61₀,..., 61ₙ₋₁) en parallèle, les lignes de mots (WL₀,..., WLₙ₋₁) de ladite pluralité de ligne de mot (WL) étant connectées respectivement aux grilles respectives desdits transistors dudit bloc (60).

11. Dispositif mémoire selon la revendication 1, dans lequel la deuxième ligne de bit est une ligne de bit complémentaire (RBLF) de la première ligne de bit (RBLT) apte à être couplée aux nœuds de stockage complémentaires respectivement desdits premiers nœuds de stockage desdites cellules de ladite première colonne (COL1), et dans lequel un premier étage (110) de circuit formant une première résistance ajustable est connecté entre la première ligne de bit (RBLT) et le premier nœud (NL10) de lecture, et dans lequel un deuxième étage (120) de circuit formant une deuxième résistance ajustable est connecté entre la ligne de bit complémentaire (RBLF) et le deuxième nœud (NL10) de lecture, la valeur dudit seuil, étant modulable en fonction des valeurs de ladite première résistance ajustable et de ladite deuxième résistance ajustable.

12. Dispositif mémoire selon la revendication 11, dans lequel le premier étage (110) de circuit formant la première résistance ajustable est doté :
- d'un premier transistor (111) ayant un état de conduction commandé par un premier signal d'activation (EN_50_T),
- d'un deuxième transistor (112) ayant un état de conduction commandé par un deuxième signal d'activation (EN_75), le deuxième transistor ayant un rapport de la largeur sur la longueur de son canal différente de celle dudit premier transistor,
le deuxième étage (120) de circuit formant la deuxième résistance ajustable étant doté :
- d'un troisième transistor (121) ayant un état de conduction commandé par un troisième signal d'activation (EN_50_F),
- d'un quatrième transistor (122) ayant un état de conduction commandé par un quatrième signal d'activation (EN_25), le quatrième transistor (122) ayant un rapport de la largeur sur la longueur de son canal différente de celle dudit troisième transistor,
le premier transistor (111) du premier étage (110) étant identique au troisième transistor (121) dudit deuxième étage (120), le quatrième transistor (122) du deuxième étage (120) étant identique au deuxième transistor (112) dudit premier étage (112).

13. Dispositif mémoire selon la revendication 12, dans lequel, l'ensemble desdits signaux d'activation (EN_50_T, EN_75, EN_50_F, EN_25) forme un signal de sélection dudit seuil, ledit seuil étant sélectionné à une première valeur de 50% lorsque le premier signal d'activation (EN_50_T) et ledit troisième signal d'activation (EN_50_F) sont adaptés de sorte à rendre passant le premier transistor (111) et le troisième transistor (121), tandis que le deuxième signal d'activation (EN_75) et le quatrième signal d'activation (EN_25) sont adaptés de sorte à bloquer respectivement le deuxième transistor (112) et le quatrième transistor (122).

14. Dispositif mémoire selon la revendication 13, ledit seuil étant sélectionné à une deuxième valeur, en particulier 25%, lorsque le premier signal d'activation (EN_50_T) et le quatrième signal d'activation (EN_25) sont adaptés de sorte à rendre respectivement passant le premier transistor (111) et le quatrième transistor (122), tandis que le deuxième signal d'activation (EN_75) et le troisième signal d'activation (EN_50_F) sont prévus de sorte à bloquer le deuxième transistor (112) et le troisième transistor (121),
ledit seuil étant sélectionné à une troisième valeur, en particulier 75%, lorsque le premier signal d'activation (EN_50_T) et le quatrième signal d'activation (EN_25) sont prévus de sorte à rendre respectivement bloqués le premier transistor (111) et le quatrième transistor (122), tandis que le deuxième signal d'activation (EN_75) et le troisième signal d'activation (EN_50_F) sont prévus de sorte à passant le deuxième transistor (112) et le troisième transistor (121).

15. Dispositif mémoire selon l'une des revendications 11 à 14, dans lequel le signal de résultat de test est produit au moyen d'un amplificateur de lecture (130) de tension intégré audit circuit de test, ledit amplificateur de lecture (130) de tension étant doté d'une première entrée connectée au premier nœud de lecture (NL10) et d'une deuxième entrée connectée audit deuxième nœud de lecture (NL20).

16. Dispositif mémoire selon la revendication 15, dans lequel ledit signal de résultat (L_OUT) de test est enregistré en sortie d'une bascule consécutivement à la réception d'un signal de déclenchement (EN).

17. Procédé de commande d'un dispositif mémoire selon l'une des revendications 1 à 16 comprenant, consécutivement à une détection d'un signal indicateur d'une tentative d'accès frauduleux à ladite matrice de cellules, l'application d'un signal de commande modifiant la résistance dudit étage formant une résistance ajustable.

## Patentansprüche

1. Speichervorrichtung mit einer Matrix von Speicherzellen, wobei die Matrix mit zumindest einer ersten Spalte (COL₁) von Zellen (C₀, Cₙ₋₁) versehen ist, wobei jede der Zellen aufweist:
- zumindest einen ersten Speicherknoten (T) zur Speicherung von logischen Daten, insbesondere "1" oder "0", deren Wert demjenigen zumindest eines Potentials am ersten Speicherknoten (T) entspricht,
- zumindest einen Leseanschluss (2), um, wenn er aktiviert ist, das Potenzial des ersten Speicherknotens (T) an eine erste Bitleitung (RBL1, RBLT) zu übertragen, die von den Zellen (C₀, Cₙ₋₁) der ersten Spalte (COL₁) von Zellen gemeinsam genutzt wird,
wobei die Vorrichtung ferner mit einer Testschaltung versehen ist, die dazu ausgelegt ist, bei einem Lesevorgang eine Testphase durchzuführen, um anzugeben, ob der Anteil der Zellen in der Spalte (COL₁), die dieselben logischen Daten, insbesondere eine logische "1", speichern, größer als zumindest ein vorbestimmter Schwellenwert ist oder nicht, wobei die Testschaltung aufweist:
- einen ersten Leseknoten (NL1, NL10), der mit einem Ende der ersten Bitleitung (RBL1, RBLT) gekoppelt ist,
- einen zweiten Leseknoten (NL2, NL20), der mit einem Ende einer zweiten Bitleitung (RBL_Dum, RBL₂) gekoppelt ist, wobei die zweite Bitleitung eine Referenzbitleitung bildet, die einer Vielzahl von zweiten Logikinformationsspeicherknoten zugeordnet ist, wobei die zweiten Speicherknoten dazu ausgelegt sind, alle dieselbe Logikinformation zu speichern, oder jeweils zu den Zellen der ersten Spalte gehören und zu den ersten Knoten komplementäre Speicherknoten sind,
**dadurch gekennzeichnet, dass** sie ferner enthält:
- zumindest eine Stufe (20, 110), die einen einstellbaren Widerstand zum Einstellen des vorbestimmten Schwellenwerts bildet, wobei die Stufe mit zumindest dem ersten Leseknoten gekoppelt ist,
wobei die Testschaltung (10, 100) ausgelegt ist zum:
- gleichzeitigen Aktivieren von k jeweiligen Leseanschlüssen einer Anzahl k von Zellen der ersten Spalte bei gleichzeitigem Aktivieren von k weiteren Leseanschlüssen einer entsprechenden Anzahl k von zweiten Speicherknoten, denen diese weiteren Leseanschlüsse zugeordnet sind, um eine Entladung der ersten Bitleitung und eine Entladung der zweiten Bitleitung und folglich eine Potentialänderung an dem ersten Leseknoten und an dem zweiten Leseknoten zu bewirken,
dann nach einer vorbestimmten Zeitspanne als eine Funktion der Potentialdifferenz zwischen dem ersten Leseknoten und dem zweiten Leseknoten
- Erzeugen zumindest eines logischen Testergebnissignals (S_OUT, L_OUT), das in Abhängigkeit von seinem Wert angibt, ob der Anteil der Zellen in der Spalte (COL1), die einen gegebenen logischen Pegel, insbesondere eine logische "1", speichern, über dem vorbestimmten Schwellenwert liegt oder nicht.

2. Speichervorrichtung nach Anspruch 1, wobei die zweite Bitleitung von Zellen einer Dummy-Spalte (Dum_COL) gemeinsam genutzt wird, wobei die zweiten Speicherknoten Speicherknoten von Dummy-Speicherzellen (Dum_CO, ... Dum_Cn-1) sind, die alle die gleichen logischen Daten, insbesondere eine logische "1", speichern.

3. Speichervorrichtung nach Anspruch 2, wobei der erste Leseknoten (NL1) mit der Schaltungsstufe (20) verbunden ist, die einen einstellbaren Widerstand bildet, wobei der Wert des Schwellenwerts zwischen mehreren vorbestimmten Werten modulierbar ist, die verschiedenen vorbestimmten Widerstandswerten der Stufe (20) entsprechen.

4. Speichervorrichtung nach Anspruch 3, wobei die einen einstellbaren Widerstand bildende Schaltungsstufe (20) mit einem Satz von m Transistoren (21, 22, 23) versehen ist, von denen jeder einen entsprechenden Ein- oder Aus-Leitungszustand aufweist und jeweils durch ein Steuersignal eines Satzes von m Steuersignalen (CMD25, CMD50, CM75) der Transistoren (21, 22, 23) gesteuert wird, wobei die Transistoren parallel geschaltet sind, so dass der Widerstandswert der genannten Stufe in Abhängigkeit von der Anzahl der eingeschalteten Transistoren unter den m Transistoren variiert, insbesondere abnimmt.

5. Speichervorrichtung nach Anspruch 4, wobei der Satz von Steuersignalen (CMD25, CMD50, CM75) ein digitales Auswahlsignal mit m Zuständen des genannten Schwellenwerts bildet, insbesondere mit m=3, wobei die vorbestimmten Schwellenwerte vorteilhafterweise 25%, 50% bzw. 75% betragen.

6. Vorrichtung nach einem der Ansprüche 2 bis 5, wobei die Testschaltung dazu ausgelegt ist, nach der Testphase eine zweite Testphase durchzuführen, um anzugeben, ob der Anteil der Zellen in der Spalte, die einen gegebenen logischen Pegel, insbesondere eine logische "1", speichern, größer als zumindest ein zweiter vorbestimmter Schwellenwert, der sich von dem ersten Schwellenwert unterscheidet, ist oder nicht.

7. Speichervorrichtung nach einem der Ansprüche 2 bis 6, wobei das Testergebnissignal (S_OUT) mittels eines in der Testschaltung integrierten Spannungskomparators (30) erzeugt wird, dessen Ausgang mittels eines Triggersignals (EN) aktiviert wird, wobei der Spannungskomparator mit einem ersten Eingang, der mit dem ersten Leseknoten (NL1) verbunden ist, und mit einem zweiten Eingang, der mit dem zweiten Leseknoten (NL2) verbunden ist, versehen ist.

8. Vorrichtung nach einem der Ansprüche 2 bis 7, wobei der erste Leseknoten (NL1) mit einem ersten Schaltungsabschnitt (40) verbunden ist, der dazu ausgelegt ist, die Potentialänderung des ersten Leseknotens (NL1) zu verlangsamen, wobei der erste Schaltungsabschnitt (40) zumindest einen Transistor (41, 42, 43) umfasst, dessen Leitung durch ein Verlangsamungssteuersignal (SLOW) gesteuert wird, dessen Amplitude von der Anzahl k der Zellen der ersten Spalte (COL1) abhängt, deren Leseanschlüsse während der Testphase aktiviert werden.

9. Vorrichtung nach einem der Ansprüche 2 bis 8, wobei der zweite Leseknoten (NL2) mit einem zweiten Schaltungsabschnitt (50) verbunden ist, der dazu ausgelegt ist, die Potentialänderung des ersten Leseknotens zu verlangsamen, wobei der zweite Schaltungsabschnitt (50) zumindest einen Transistor (51) umfasst, dessen Leitung durch ein Verlangsamungssteuersignal (SLOW) gesteuert wird, dessen Amplitude in Abhängigkeit von der Anzahl k der Zellen der ersten Spalte, deren Leseanschlüsse aktiviert sind, moduliert wird.

10. Vorrichtung nach Anspruch 9, wobei ein Leseanschluss einer Zelle über eine Wortleitung aktiviert wird, die von den Zellen einer gleichen Zeile von Zellen der Matrix gemeinsam genutzt wird, und wobei die Matrix von Zellen mehrere Zeilen und eine Vielzahl von zugeordneten Wortleitungen (WL₀, ..., WLₙ₋₁) umfasst, wobei die Testschaltung ferner einen Schaltungsblock (60) zum Erzeugen des Verlangsamungssteuersignals (SLOW) für den Transistor (41, 42, 43) des ersten Schaltungsabschnitts (40) und den Transistor (51) des zweiten Schaltungsabschnitts (50) aufweist, wobei der Schaltungsblock (60) mit einer Vielzahl von parallel geschalteten Transistoren (61₀, ..., 61ₙ₋₁) versehen ist, wobei die Wortleitungen (WL₀, ..., WLₙ₋₁) der Vielzahl von Wortleitungen (WL) jeweils mit den entsprechenden Gates der Transistoren des Blocks (60) verbunden sind.

11. Speichervorrichtung nach Anspruch 1, wobei die zweite Bitleitung eine komplementäre Bitleitung (RBLF) zur ersten Bitleitung (RBLT) ist, die mit den jeweils komplementären Speicherknoten der ersten Speicherknoten der Zellen der ersten Spalte (COL1) gekoppelt werden kann, und wobei eine erste Schaltungsstufe (110), die einen ersten einstellbaren Widerstand bildet, zwischen der ersten Bitleitung (RBLT) und dem ersten Leseknoten (NL10) geschaltet ist, und wobei eine zweite Schaltungsstufe (120), die einen zweiten einstellbaren Widerstand bildet, zwischen der komplementären Bitleitung (RBLF) und dem zweiten Leseknoten (NL10) geschaltet ist, wobei der Wert des Schwellenwerts in Abhängigkeit von den Werten des ersten einstellbaren Widerstands und des zweiten einstellbaren Widerstands modulierbar ist.

12. Speichervorrichtung nach Anspruch 11, wobei die erste Schaltungsstufe (110), die den ersten einstellbaren Widerstand bildet, versehen ist mit:
- einem ersten Transistor (111) mit einem Leitungszustand, der durch ein erstes Aktivierungssignal (EN_50_T) gesteuert wird,
- einem zweiten Transistor (112) mit einem Leitungszustand, der durch ein zweites Aktivierungssignal (EN_75) gesteuert wird, wobei der zweite Transistor ein anderes Verhältnis von Breite zu Länge seines Kanals hat als der erste Transistor,
wobei die zweite Schaltungsstufe (120), die den zweiten einstellbaren Widerstand bildet, versehen ist mit:
- einem dritten Transistor (121) mit einem Leitungszustand, der durch ein drittes Aktivierungssignal (EN_50_F) gesteuert wird,
- einem vierten Transistor (122) mit einem Leitungszustand, der durch ein viertes Aktivierungssignal (EN_25) gesteuert wird, wobei der vierte Transistor (122) ein anderes Verhältnis von Breite zu Länge seines Kanals hat als der dritte Transistor,
wobei der erste Transistor (111) der ersten Stufe (110) mit dem dritten Transistor (121) der zweiten Stufe (120) identisch ist und der vierte Transistor (122) der zweiten Stufe (120) mit dem zweiten Transistor (112) der ersten Stufe (112) identisch ist.

13. Speichervorrichtung nach Anspruch 12, wobei der Satz von Aktivierungssignalen (EN_50_T, EN_75, EN_50_F, EN_25) ein Auswahlsignal für den Schwellenwert bildet, wobei der Schwellenwert mit einem ersten Wert von 50 % gewählt wird, wenn das erste Aktivierungssignal (EN_50_T) und das dritte Aktivierungssignal (EN_50_F) dazu ausgelegt sind, den ersten Transistor (111) und den dritten Transistor (121) einzuschalten, während das zweite Aktivierungssignal (EN_75) und das vierte Aktivierungssignal (EN_25) dazu ausgelegt sind, den zweiten Transistor (112) bzw. den vierten Transistor (122) auszuschalten.

14. Speichervorrichtung nach Anspruch 13, wobei der Schwellenwert mit einem zweiten Wert, insbesondere 25 %, gewählt wird, wenn das erste Aktivierungssignal (EN_50_T) und das vierte Aktivierungssignal (EN_25) dazu ausgelegt sind, den ersten Transistor (111) bzw. den vierten Transistor (122) einzuschalten, während das zweite Aktivierungssignal (EN_75) und das dritte Aktivierungssignal (EN_50_F) dazu vorgesehen sind, den zweiten Transistor (112) und den dritten Transistor (121) auszuschalten,
wobei der Schwellenwert mit einem dritten Wert, insbesondere 75 %, gewählt wird, wenn das erste Aktivierungssignal (EN_50_T) und das vierte Aktivierungssignal (EN_25) dazu vorgesehen sind, den ersten Transistor (111) bzw. den vierten Transistor (122) auszuschalten, während das zweite Aktivierungssignal (EN_75) und das dritte Aktivierungssignal (EN_50_F) dazu vorgesehen sind, den zweiten Transistor (112) und den dritten Transistor (121) einzuschalten.

15. Speichervorrichtung nach einem der Ansprüche 11 bis 14, wobei das Testergebnissignal mittels eines in die Testschaltung integrierten Spannungsleseverstärkers (130) erzeugt wird, wobei der Spannungsleseverstärker (130) einen mit dem ersten Leseknoten (NL10) verbundenen ersten Eingang und einen mit dem zweiten Leseknoten (NL20) verbundenen zweiten Eingang aufweist.

16. Speichervorrichtung nach Anspruch 15, wobei das Testergebnissignal (L_OUT) am Ausgang eines Flipflops nach dem Empfang eines Triggersignals (EN) erfasst wird.

17. Verfahren zur Steuerung einer Speichervorrichtung nach einem der Ansprüche 1 bis 16, bei dem nach der Erfassung eines Signals, das einen versuchten betrügerischen Zugriff auf die Zellenmatrix angibt, ein Steuersignal angelegt wird, das den Widerstand der einen einstellbaren Widerstand bildenden Stufe verändert.

## Claims

1. A memory device comprising a matrix of memory cells, the matrix being provided with at least one first column (COL₁) of cells wherein each of said cells (C₀, Cₙ₋₁) comprises:
- at least one first storage node (T) to store logical data, particularly "1" or "0", the value of which corresponds to the value of at least one potential at said first storage node (T),
- at least one read port (2) that, when activated, transmits the potential of the first storage node to a first bit line (RBL1, RBLT) shared by the cells (C₀, Cₙ₋₁) in the first column (COL1) of cells,
the device further being provided with a test circuit configured to perform a test phase during a read operation to indicate whether or not the proportion of cells in said column storing the same logical data, particularly a logical '1', is greater than a predetermined threshold, said test circuit comprising:
- a first read node (NL1, NL10) coupled to one end of the first bit line (RBL1, RBLT),
- a second read node (NL2, NL20) coupled to one end of a second bit line (RBL_Dum, RBL2), the second bit line forming a reference bit line associated with a plurality of second logical information storage nodes, said second storage nodes being configured to all store the same logical information or belonging to said cells in said first column respectively, and being storage nodes complementary to said first nodes, characterized it further comprises:
- at least one stage (20, 110) forming a variable resistance to adjust said predetermined threshold, said stage being coupled to at least the first read node,
said test circuit (10, 100) being configured to:
- concomitantly activate k read ports of a number k of cells in said first column while simultaneously activating k other read ports of a corresponding number k of second storage nodes with which these other read ports are associated, to cause discharge of the first bit line and discharge of the second bit line and consequently cause a variation of the potential at said first read node and at the second read node and then, after a predetermined duration, depending on the difference in potentials between said first read node and said second read node:
- produce at least one logical test result signal (S_OUT, L_OUT) indicating whether or not the proportion of cells in said column (COL1) storing a given logical level, in particular a logical "1", is greater than said predetermined threshold, as a function of its value.

2. The memory device according to claim 1, wherein the second bit line is shared by cells in a dummy column (Dum_COL), the second storage nodes being storage nodes of dummy memory cells (Dum_C0,..., Dum_Cn-1) all storing the same logical data, and particularly a logical '1'.

3. The memory device according to claim 2, wherein the first read node (NL1) is connected to the circuit stage (20) forming a variable resistance, the value of said threshold can be modulated between several predetermined values corresponding to different predetermined resistance values of said stage (20).

4. The memory device according to claim 3, wherein the circuit stage (20) forming a variable resistance is provided with a set of m transistors (21, 22, 23) each having a corresponding conducting or blocked conduction state and controlled by a control signal of a set of m transistor control signals (CMD25, CMD50, CMD75), the transistors (21, 22, 23) being arranged in parallel such that the resistance value of said stage varies, and in particular reduces, as a function of the number of transistors among the m transistors that are made conducting.

5. The memory device according to claim 4, the set of control signals (CMD25, CMD50, CMD75) forms a digital selection signal with m states of said threshold, particularly with m=3, the predetermined thresholds advantageously being 25%, 50%, 75% respectively.

6. The memory device according to any of the claims 2 to 5, wherein the test circuit is configured so that, after said test phase, a second test phase is performed to indicate whether or not the proportion of cells in said column storing a given logical level, and particularly a logical '1', is greater than at least one second predetermined threshold different from the first threshold.

7. The memory device according to any of the claims 2 to 6, wherein the test result signal (S_OUT) is produced by means of a voltage comparator integrated into the test circuit and the output of which is activated by means of a trigger signal (EN), said voltage comparator being provided with a first input connected to the first read node (NL1) and a second input connected to said second read node (NL2).

8. The memory device according to any of the claims 2 to 7, wherein the first read node (NL1) is connected to a first circuit portion configured to slow said potential variation of said first read node, said first circuit portion (40) comprising at least one transistor (41, 42, 43) the conduction of which is controlled by a delay control signal (SLOW), the amplitude of which depends on said number k of cells in said first column (COL1) for which the read ports are activated during said test phase.

9. The memory device according to any of the claims 2 to 8, wherein the second read node (NL2) is connected to a second circuit portion (50) configured to slow said potential variation of said first read node, said second circuit portion comprising at least one transistor (51) the conduction of which is controlled by a delay control signal (SLOW), the amplitude of which is modulated as a function of the number k of cells in said first column for which the read ports are activated.

10. The memory device according to claim 9, wherein a read port of a cell is activated by means of a word line (WL₀,..., WLₙ₋₁) shared by the cells in the same line of cells in the matrix, and wherein the cells matrix comprises several lines and a plurality of associated word lines, said test circuit further comprising a circuit block (60) to produce the delay control signal addressed to said transistor of said first circuit portion and said transistor (41, 42, 43) of said second circuit portion, said circuit block (60) being provided with a plurality of transistors (61₀,..., 61ₙ₋₁) in parallel, the word lines of said plurality of word lines (WL₀,..., WLₙ₋₁) being connected to the gates of said transistors of said block (60) respectively.

11. The memory device according to claim 1, wherein the second bit line is a bit line complementary (RBLF) to the first bit line (RBLT) that can be coupled to storage nodes complementary to said first storage nodes of said cells in said first column(COL1), and in which a first circuit stage (110) forming a first variable resistance is connected between the first bit line (RBLT) and the first read node (NL10), and in which a second circuit stage (120) forming a second variable resistance is connected between the complementary bit line (RBLF) and the second read node (NL10), the value of said threshold being modulable as a function of the values of said first variable resistance and said second variable resistance.

12. The memory device according to claim 11, wherein the first circuit stage (110) forming the first variable resistance is provided with:
- a first transistor (111) having a conduction state controlled by a first activation signal (EN_50_T),
- a second transistor (112) having a conduction state controlled by a second activation signal (EN_75), the second transistor having a channel width to length ratio different from that of said first transistor,
the second circuit stage (120) forming the second variable resistance being provided with:
- a third transistor having a conduction state controlled by a third activation signal (EN_50_F),
- a fourth transistor (122) having a conduction state controlled by a fourth activation signal, the fourth transistor having a channel width to length ratio different from that of said third transistor, the first transistor (111) of the first stage (110) being identical to the third transistor (121) of said second stage (120), the fourth transistor (122) of the second stage being identical to the second transistor of said first stage (112).

13. The memory device according to claim 12, wherein the set of said activation signals (EN_50_T, EN_75, EN_50_F, EN_25) forms a selection signal of said threshold, said threshold being selected at a first value of 50% when the first activation signal (EN_50_T) and said third activation signal (EN_50_F) are adapted so as to make the first transistor (111) and the third transistor (121) conducting, while the second activation (EN_75) signal and the fourth activation signal (EN_25) are adapted so as to block the second transistor (112) and the fourth transistor respectively (122).

14. The memory device according to claim 13, wherein the test threshold is selected to be equal to a second value, particularly 25%, when the first activation signal (EN_50_T) and the fourth activation signal (EN_25) are adapted so as to make the first transistor and the fourth transistor respectively conducting, while the second activation signal (EN_75) and the third activation signal (EN_50_F) are designed so as to block the second transistor (112) and the fourth transistor (121) respectively.
said test threshold being selected to be equal to a third value, particularly 75%, when the first activation signal and the fourth activation signal are designed so as to make the first transistor and the fourth transistor respectively blocked, while the second activation signal (EN_75) and the third activation signal (EN_50_F) are designed so as to make the second transistor (112) and the third transistor (121) respectively conducting.

15. The memory device according to any of the claims 11 to 14, wherein the test result signal is produced by means of a voltage read amplifier integrated (130) into said test circuit, said voltage read amplifier (130) being provided with a first input connected to the first read node (NL10) and a second input connected to said second read node (NL20).

16. The memory device according to claim 15, wherein said test result signal (L_OUT) is saved at the output from a latch following reception of a trigger signal (EN).

17. A method for controlling a memory device according to any of the claims 1 to 16, comprising: application of a control signal modifying the resistance of said stage forming a variable resistance following detection of a signal indicating a fraudulent attempt to access said cells matrix.
